# EUROPEAN PATENT SPECIFICATION

(11) **EP 2 014 787 B1**
(45) Date of publication and mention of the grant of the patent: **06.09.2017**
(21) Application number: 07828318.1
(22) Date of filing: 25.09.2007
(51) Int. Cl.: C23C 14/34, H01L 21/285, H01L 21/3205, H01L 23/52, H01L 23/532

(54) **Cu-Mn ALLOY SPUTTERING TARGET**
CU-MN-LEGIERUNGS-SPUTTERTARGET
CIBLE DE PULVÉRISATION CATHODIQUE D'ALLIAGE Cu-Mn

(30) Priority: 03.10.2006 JP 2006271449
(43) Date of publication of application: 14.01.2009
(73) Proprietor: JX Nippon Mining & Metals Corporation, Tokyo 100-8164 (JP)
(72) Inventor: IRUMATA, Shuichi, Kitaibaraki-shi Ibaraki 319-1535 (JP); MIYATA, Chisaka, Kitaibaraki-shi Ibaraki 319-1535 (JP)
(74) Representative: Bond, Christopher William
(86) International application number: PCT/JP2007/068501
(87) International publication number: WO 2008/041535

(56) References cited:
- WO-A-2006/025347
- WO-A-2007/100125
- WO-A1-2007/020981
- JP-A- 06 140 398
- JP-A- 11 186 273
- JP-A- 2002 294 437
- JP-A- 2005 154 814
- JP-A- 2005 200 738
- JP-A- 2006 073 863
- JP-A- 2007 051 351
- US-B1- 6 607 982

## Description

### TECHNICAL FIELD

The present invention generally relates to a copper alloy wiring sputtering target for semiconductor application capable of effectively preventing contamination around the wiring caused by diffusion of active Cu, and in particular relates to a Cu-Mn alloy sputtering target suitable for forming a semiconductor wiring comprising a self-diffusion suppression function, and a copper alloy wiring for semiconductor application.

### BACKGROUND ART

Conventionally, although Al (resistivity of roughly 3.0*µ* Ω·cm) has been used as the wiring material of a semiconductor device, low-resistivity copper wiring (resistivity of roughly 1.7*µ* Ω·cm) has been put into practical application pursuant to the miniaturization of wiring. As the current formation process of copper wiring, generally, a diffusion barrier layer of Ta or TaN is formed in the concave portion of a contact hole or wiring groove, and copper or copper alloy is thereafter subject to sputter deposition.

Generally, electrolytic copper having a purity of roughly 4N (excluding gas components) as the crude metal is subject to a wet or dry high purification process to manufacture high purity copper having a purity of 5N to 6N, and this is used as the sputtering target.

Although copper or copper alloy is extremely effective as a semiconductor wiring material, copper itself is an extremely active metal and diffuses easily, and there is a problem in that the Si substrate or the periphery thereof is contaminated through the semiconductor Si substrate or the insulating film formed thereon. Thus, with conventional technology, the formation of a diffusion barrier layer of Ta or TaN is an inevitable process. However, since this entails a problem of increased processing steps, it is not necessarily the optimal means. In substitute for this diffusion barrier layer, a self-forming diffusion barrier layer by subjecting a copper alloy to deposition and heat treatment is proposed. Nevertheless, currently there is no simple and effective means for achieving such self-forming diffusion barrier layer.

Meanwhile, as copper wiring materials, materials of several elements added to copper are proposed in order to improve electromigration (EM) resistance, corrosion resistance, bond strength and so on.

Some examples are listed below. Patent Document 1 describes a sputtering target containing 10% or less of one type or two types or more among the elements of Al, Ag, B, Cr, Ge, Mg, Nd, Si, Sn, Ti, and Zr as the elements to be normally added to high purity copper (4N or higher).

Patent Document 2 describes a high purity copper alloy sputtering target using high purity copper of 99.9999wt% or higher as the base metal, and adding 0.04 to 0.15wt% of titanium having a purity level of 99.9wt% or higher or 0.014 to 0.021wt% of zinc having a purity level of 99.9999wt% to the base metal.

Patent Document 3 describes a copper alloy sputtering target of 99.99% or higher in which the Mg content is 0.02 to 4wt%.

Patent Document 4 discloses a method of forming a barrier layer by forming a compound with an interlayer insulating film containing metal elements of Mn, Nb, Zr, Cr, V, Y, Tc and Re, elements selected from Si, C, and F, and oxygen. Nevertheless, the foregoing background art entail a problem in that they are not necessarily sufficient in preventing the diffusion of copper.

In addition, as a semiconductor device wiring material previously proposed by Applicant, Patent Document 5 discloses a method of forming a uniform seed layer from a copper alloy containing 0.4 to 5wt% of Sn, and a target having superior sputter deposition characteristics. Although Patent Document 5 is effective as a seed layer, it does not aim to form a barrier layer.

Applicant has previously disclosed a copper alloy wiring material for semiconductor application formed from Cu-Mn alloy, and in particular Patent Document 6 proposes a copper alloy wiring for semiconductor application formed from Cu-Mn alloy comprising a self-diffusion suppression function and in which the total amount of one or two or more elements selected from Sb, Zr, Ti, Cr, Ag, Au, Cd, In, and As is 10wtppm or less. Patent Document 6 in itself is extremely effective for forming a barrier film. The present invention proposes an improved invention thereof.

A diffusion barrier layer formed from tantalum or the like must also be subject to deposition thinly and uniformly pursuant to the miniaturization of the wiring rule. For example, Patent Document 7 relates to a copper alloy thin film in which Mg is added to Cu, and describes that a diffusion barrier and a seed layer can be formed simultaneously by moving Mg atoms to form MgO. Due to heat treatment, the Mg in the Cu-Mg alloy reacts with the oxygen of the interlayer insulating film and forms a barrier layer through self-formation. Patent Document 7 also describes that a process for forming a barrier layer formed from tantalum or the like is not required. Nevertheless, there is a problem of reliability concerning the diffusion barrier and a problem in the increase of wiring resistance.

Patent Document 8 describes Cu-Mn as one solid solution strengthened Cu alloy manufactured with a semiconductor device provided with wiring on a semiconductor layer via an insulating film, wherein the tensile strength of the wiring is 25kg/mm² or greater, and specific tensile strength can be obtained by suitably selecting the additive amount of the element to be added and performing heat treatment thereto. Nevertheless, the Mn content is unclear, and it cannot be said that Patent Document 8 possesses a self-diffusion suppression function that is suitable for forming a copper alloy wiring for semiconductor application.

Since aluminum and aluminum alloy electrode wiring has low EM resistance, disconnection easily occurs, and pure copper wiring has inferior corrosion resistance. Thus, Patent Document 9 proposes copper alloy as an electrode wiring material of an integrated circuit device, and describes that manganese copper alloy (up to 20%Mn) can be put to practical application. Patent Document 9 also describes that manganese copper alloy has superior oxidation resistance and halogen resistance in comparison to copper alone and, although it is not possible to prevent the increase in the wiring resistance, the wiring resistance can be maintained to be at the same level as aluminum alloy. Patent Document 9 also describes the formation of an electrode film via CVD, sputter deposition, and electroplating. Nevertheless the resistance of Patent Document 9 is too large, and is unfit as a semiconductor wiring material.

Patent Document 10 describes using Mn film, Mn boride film, or Mn nitride film as the barrier film for covering the entire or partial face of the Cu wiring; in particular the substrate side thereof so as to form a crystal grain boundary of alloy of Cu and Mn and prevent Cu diffusion. Conventionally, although nitrides and borides such as Zr, Ti, and V have been used as the barrier material, these barrier materials have a relatively large grain size, and there is a problem in that the Cu diffusion cannot be sufficiently prevented. Nevertheless, as a result of using Mn, Mn borides, and Mn nitrides as the barrier material to cover the Cu wiring surface as described above, the alloy of Cu and Mn having superior heat-resistant stability at the interface of Cu and Mn, Cu and Mn borides (Mn-B), or Cu and Mn nitrides (Mn-N) is formed extremely thin, and the crystal grain boundary of such alloy of Cu and Mn is considered to inhibit the Cu diffusion.

Nevertheless, in this case, since Mn, Mn borides, and Mn nitrides are newly used as the barrier material on the copper wiring to cover the Cu wiring surface, this does not improve the copper diffusion suppression effect of the copper wiring itself. In addition, there is another problem in that an additional step for covering Mn, Mn borides, and Mn nitrides is required, and Patent Document 10 does not provide a fundamental solution.

Patent Document 11 describes a method of using Mg, Mn or the like as the additive element, forming an insulating film on the semiconductor substrate, forming a wiring groove on this surface, and embedding a Cu-4at.% Mg wiring layer, which is an embedded wiring layer formed from a Cu film where 4 at.% Mg is dissolved in solid is buried in the wiring groove through the intermediary of a TiN protective film formed by covering the base and side wall of the groove. An MgO film which functions as an antioxidizing barrier to protect the Cu-4at.% Mg wiring layer against oxidation is formed on the Cu-4at.% Mg wiring layer.

Nevertheless, since the addition of Mn in the Cu film is within the limit of a solid solution, this means that the concentration of elements is lower than the concentration required for forming Cu and the intermetallic compound. Thus, since Cu and the additive elements are not in a state of forming an intermetallic compound, there is a problem in that this is not necessarily a sufficient barrier film.

Patent Document 12 describes a copper alloy sputtering target having small crystal grain grown upon bonding a target and a backing plate via hot isostatic press. The copper alloy sputtering target has a composition comprising a total of one or more types of components selected from the group of V, Nb, Mn, Fe, Co, and Ni, and one or more types of components selected from the group of Sc, Al, Y, and Cr, so as to be 0.005 to 0.5 wt% in total, 0.1 to 5 ppm oxygen, and the balance Fe and unavoidable impurities. Among the above, Patent Document 12 describes that a desired effect cannot be obtained if the amount is less than 0.005wt%, and, if the amount exceeds 0.5wt%, the growth of crystal grains during the hot isostatic press will be inhibited. Nevertheless, even if the amount is 0.05wt% or less, the fact remains that a barrier film is required upon forming the wiring. Further, a barrier film is similarly required if only Mn is not 0.05wt% or less.

In addition, disclosed are a copper target superior in electromigration resistance by controlling the crystal orientation (refer to Patent Documents 13, 14, 15), a high purity copper target superior in film thickness uniformity (refer to Patent Document 16), a copper target in which the sputtering direction of copper atoms is perpendicular to the substrate surface (refer to Patent Document 17), a copper or a copper alloy target that seeks the uniformity of a film by realizing crystals of irregular orientation and reducing particles (refer to Patent Document 18), and a copper target having four types of orientations (111), (200), (220), (311), and a method of processing and manufacturing such target (refer to Patent Documents 19, 20). Nevertheless, the patent documents are limited to controlling the crystal orientation, and are not intended to inhibiting the contamination around the wiring caused by Cu diffusion, and the correlation between the composition of the copper alloy target for forming the barrier film and the crystal orientation is unclear either.
[Patent Document 1] Japanese Patent Laid-Open Publication No. 2000-239836
[Patent Document 2] Japanese Patent No. 2862727
[Patent Document 3] Japanese Patent Laid-Open Publication No. 2000-34562
[Patent Document 4] Japanese Patent Laid-Open Publication No. 2005-277390
[Patent Document 5] International Publication No. WO2003/064722
[Patent Document 6] Japanese Patent Laid-Open Publication No. 2006-73863
[Patent Document 7] U.S. Patent No. 6607982
[Patent Document 8] Japanese Patent Laid-Open Publication No. H02-50432
[Patent Document 9] Japanese Patent Laid-Open Publication No. H02-119140
[Patent Document 10] Japanese Patent Laid-Open Publication No. H06-140398
[Patent Document 11] Japanese Patent Laid-Open Publication No. H11-186273
[Patent Document 12] Japanese Patent Laid-Open Publication No. 2002-294437
[Patent Document 13] Japanese Patent Laid-Open Publication No. H10-195609
[Patent Document 14] Japanese Patent Laid-Open Publication No. H10-195610
[Patent Document 15] Japanese Patent Laid-Open Publication No. H10-195611
[Patent Document 16] Japanese Patent Laid-Open Publication No. H10-330923
[Patent Document 17] Japanese Patent Laid-Open Publication No. 2001-40470
[Patent Document 18] Japanese Patent Laid-Open Publication No. 2001-49426
[Patent Document 19] Japanese Patent Laid-Open Publication No. 2002-220659
[Patent Document 20] Japanese Patent Laid-Open Publication No. 2004-52111
WO2006/025347 describes a copper alloy comprising an additive element which is dissolved in the copper in an amount of 0.1 to 20 at%.

### DISCLOSURE OF THE INVENTION

According to the present invention, there is provided a Cu-Mn alloy sputtering target as defined in claim 1 hereinafter.

Embodiments of the present invention provide a copper alloy wiring for semiconductor application and a sputtering target for forming such a copper alloy wiring in which the copper alloy wiring for semiconductor application is equipped with a self-diffusion suppression function and capable of effectively preventing the contamination around the wiring caused by the diffusion of active Cu, and improving the electromigration (EM) resistance, corrosion resistance, and so on.

In order to overcome the foregoing problems, as a result of intense study, the present inventors discovered that the contamination around the wiring caused by the diffusion of active Cu can be effectively prevented by adding an appropriate amount of Mn to copper, and strictly controlling the impurities of Be, B, Mg, Al, Si, Ca, Ba, La, and Ce. Based on this discovery, embodiments of the present invention provide a sputtering target for forming a copper alloy wiring for semiconductor application, and a copper alloy wiring for semiconductor application.

Specifically, one embodiment of the present invention provides a Cu-Mn alloy sputtering target, wherein the Mn content is 0.05 to 20wt%, the total amount of Be, B, Mg, Al, Si, Ca, Ba, La, and Ce is 500wtppm or less, and the remainder is Cu and unavoidable impurities.

Mn in the Cu-Mn alloy diffuses in the interface direction in relation to the Si semiconductor, and forms oxides of Mn and Si. This oxide layer becomes the barrier layer for controlling the reaction of Mn and Si. Here, since the impurity elements of Be, B, Mg, Al, Si, Ca, Ba, La, and Ce more easily form oxides in comparison to Mn, they obstruct the formation of oxides of Mn and Si, and inhibit the formation of the barrier layer. Thus, it could be said that these impurity elements should be reduced as much as possible. This discovery is extremely important and constitutes the core of this invention.

Preferably, the total amount of impurities such as Be, B, Mg, Al, Si, Ca, Ba, La, and Ce is 50wtppm or less, and more preferably the total amount of Be, B, Mg, Al, Si, Ca, Ba, La, and Ce is 10wtppm or less.

In addition, in order to reduce the particles generated during sputtering in the Cu-Mn alloy sputtering target, preferably, the oxygen content is 100wtppm or less, and more preferably the oxygen content is 50wtppm or less.

As the structure of the Cu-Mn alloy sputtering target for forming a semiconductor wiring, when the area ratio of a target surface in a case where a close-packed (111) face measured with EBSP (Electron Back Scatter Diffraction Pattern) is evenly distributed in all directions is 1, preferably, the area ratio of the (111) face of the target surface is 4 or less. The Cu-Mn alloy semiconductor wiring is effective as a wiring material to be formed in the concave portion of a contact hole or a wiring groove, and therefore also effective as a seed layer for forming the copper wiring layer.

With the copper alloy wiring for semiconductor application, the sputtering target for forming this wiring, and the manufacturing method of a copper alloy wiring for semiconductor application according to embodiments of the present invention, copper alloy wiring itself for semiconductor application is equipped with a self-diffusion suppression function for effectively preventing the contamination around the wiring caused by the diffusion of active Cu, improving electromigration (EM) resistance, corrosion resistance and the like, enabling and facilitating the arbitrary formation of a barrier layer, and simplifying the deposition process of the copper alloy wiring for semiconductor application. In addition, embodiments of the present invention yield a significant effect of being able to arbitrarily and stably form a barrier layer formed of manganese oxide on the upper face, lower face and peripheral face of the copper alloy wiring film, and simplify the deposition process of the copper alloy wiring and the formation process of the barrier layer. Moreover, by controlling the area ratio of the (111) face, an effect is yielded in that the uniformity of deposition during sputtering becomes favorable and the generation of particles is also reduced.

With the copper alloy wiring (including the seed layer) for semiconductor application comprising the self-diffusion suppression function of embodiments of the present invention, as described above, the Mn content is 0.05 to 20wt%, the total amount of Be, B, Mg, Al, Si, Ca, Ba, La, and Ce is 500wtppm or less, and the remainder is Cu and unavoidable impurities. In other words, embodiments of the present invention provide a Cu-Mn alloy sputtering target and a Cu-Mn alloy semiconductor wiring formed thereby. The conditions defined by the Cu-Mn alloy sputtering target are the necessary and sufficient conditions for exhibiting the effect of embodiments of the present invention. The more preferable conditions described below show the conditions of a further improved embodiment.

If the Mn content is less than 0.05wt%, this is not preferable since the self-diffusion suppression function cannot be attained. If the Mn content exceeds 20wt%, this is not preferable since the resistance will increase and the function as a copper alloy wiring (seed layer) for semiconductor application will deteriorate. Thus, the Mn content is set to be within the range of 0.05 to 20wt%. More preferably, the copper alloy contains 0.5 to 10wt% of Mn.

Normally, since La is used as the deoxidizing agent in manufacturing, Mn contains several thousands of ppm of La. This is included in the Cu-Mn alloy and forms the problematic impurities.

Copper (pure copper) entails a problem of reaching the insulating layer or the semiconductor Si substrate and often becoming a contamination source. This is a problem that has been indicated from the past, and proposals have been made for forming a barrier film between the insulating film and the copper wiring film to overcome the foregoing problem.

Representative barrier films are formed from metals such as Zr, Ti, V, Ta, Nb, and Cr or nitrides or borides. Nevertheless, these components have a large grain size in the thin film, and are inappropriate as a barrier film of Cu.

Accordingly, as shown in Patent Document 7 described above, proposals have been made for forming a barrier film formed from Mn, Mn borides, or Mn nitrides on the copper surface.

Nevertheless, this method entails a problem of having to separately implement the coating process, and this barrier film in itself does not yield the effect of inhibiting the diffusion of Cu. Thus, contamination could obviously occur at locations other than the locations where the barrier film is formed. Like this, the foregoing proposals have a limited barrier effect and are disadvantageous due to increased costs. Embodiments of the present invention, as described above, adds a slight amount of Mn to Cu alloy so as to inhibit the diffusion of Cu itself, and this effect can be continuously yielded in any situation (face) of the Cu-Mn alloy film. The Mn in the Cu-Mn alloy film diffuses and reaches the interface of the Si semiconductor, and forms oxides of Mn and Si (nonstoichiometric oxides of MnSiₓO_{y}). Oxygen is assumed to be consumed by the impurities in the Cu-Mn alloy film. Since the conductivity of the center of the wiring will improve as a result of the oxides being unevenly distributed on the interface, it could be said that this is a preferable reaction.

This layer is located at the interface of the Si semiconductor and the copper alloy conductive (wiring) layer, and a layer of up to roughly 2nm is formed. Once this layer is formed, the diffusion of Mn in the Si semiconductor layer is prevented. In other words, this becomes the barrier layer. Since this yields the self-diffusion suppression function by forming the copper alloy wiring, it can be easily understood that this is an extremely simple and effective method.

Conventionally, a Ta barrier layer was used, but in this case, the Ta barrier layer needs to be formed in a separate sputtering process, and a uniform film needs to be formed to sufficiently maintain the function as a barrier film. Thus, the Ta film needed to have a film thickness of at least 15nm. The advantage of the embodiment of the present invention is obvious in comparison to this kind of conventional Ta barrier layer. Nevertheless, a problem arose in that the function as a barrier film in a copper alloy wiring for semiconductor application would deteriorate due to trace amounts of impurities that were previously ignored. This became obvious from the fact that the function of the barrier film varied depending on the manufactured Cu-Mn alloy target. Generally, when manufacturing a Cu-Mn alloy target, high purity (99.9wt % or higher) material is used. Still, the total amount of impurity elements would often exceed 500wtppm. As a result of investigating this cause, it was discovered that the existence of Be, B, Mg, Al, Si, Ca, Ba, La, and Ce has a significant influence. These elements have something in common; that is, all of these impurity elements have stronger oxidizing power than Mn. Thus, before the Mn in the Cu-Mn alloy film diffuses and reaches the interface of the Si semiconductor to form the oxides of Mn and Si (nonstoichiometric oxides of MnSiₓO_{y}), the oxides of Be, B, Mg, Al, Si, Ca, Ba, La, and Ce are formed. In other words, this is considered to be because the impurity elements in the Cu-Mn alloy film consume the oxygen, and the formation of the barrier layer from the oxides of Mn and Si is not sufficiently performed. Thus, when a barrier layer is not formed, active Cu will diffuse in the Si, and deteriorate the function.

In light of this, a method of increasing the amount of oxygen in the Cu-Mn alloy film to supplement the consumed oxygen can be considered. Nevertheless, excess oxides cause deterioration in the wiring conductivity, and this is not preferable.

Accordingly, it is necessary to reduce the inclusion of impurities such as Be, B, Mg, Al, Si, Ca, Ba, La, and Ce as much as possible.

Moreover, as the structure of the Cu-Mn alloy sputtering target for forming the semiconductor wiring of embodiments of the present invention, when the area ratio of a target surface in a case where a close-packed (111) face measured with EBSP (Electron Back Scatter Diffraction Pattern) is evenly distributed in all directions is 1, the area ratio of the (111) face of the target surface is preferably 4 or less, more preferably 3 or less.

When the close-packed (111) face of the Cu-Mn alloy sputtering target is evenly distributed in all directions, a significant effect is yielded in that the uniformity of deposition is favorable. If the area ratio of the (111) face exceeds 4, the uniformity of deposition will become inferior, the generation of particles tends to increase, the sputter rate of Cu and Mn is affected, and non-uniformity becomes noticeable. Thus, it is desirable that the area ratio of the (111) face of the target surface is 4 or less.

As the current formation process of copper wiring, generally, a diffusion barrier layer of Ta or TaN is formed in the concave portion of a contact hole (via hole) or wiring groove, and copper or copper alloy is thereafter subject to sputter deposition, embodiments of the present invention are not limited thereto.

In other words, the copper alloy wiring for semiconductor application is also able to form a Mn oxide film in which the Mn in the copper alloy is preferentially oxidized (selectively oxidized) on the upper face, side face and bottom face (i.e., peripheral face) of the wiring. This in itself can be made to function as a barrier layer.

This Mn oxide film layer can be formed by once sputtering a target to form a copper alloy wiring, and performing heat treatment thereto in an oxygen-containing atmosphere to preferentially oxidize the Mn in the copper alloy on the surface of the wiring so as to form a Mn oxide film. This heat treatment is preferably performed in the range of 200 to 525°C. The formation of this kind of barrier layer does not require the formation process of an additional thin film, and yields a superior effect of providing an extremely simple manufacture process.

The method of forming the copper alloy wiring for semiconductor application of embodiments of the present invention may adopt the sputtering method, CVD method, plating method, ion cluster coating method, vapor deposition method, laser abrasion method or the like, and there is no particular limitation on the method that can be used.

Nevertheless, the sputtering method is able to perform deposition the most efficiently and stably. Thus, the target with the foregoing composition is used as the sputtering target for forming the copper alloy wiring for semiconductor application comprising the self-diffusion suppression function.

Since the component composition of this kind of target is directly reflected in the sputtered film, it must be managed sufficiently. Further, the amount to be added is based on the same reason described above regarding the wiring film.

The total amount of Be, B, Mg, Al, Si, Ca, Ba, La, and Ce as impurities contained in the target is 500wtppm or less, preferably 50wtppm or less, and more preferably 10wtppm or less. These elements raise the recrystallization temperature of copper, miniaturize the grainsize of the copper alloy film after heat treatment and increase the resistance, and also inhibit the diffusion effect of Mn. Thus, it is desirable to limit these impurities to be within the foregoing range.

The gas components of oxygen, nitrogen, carbon, sulfur, and chlorine included in the copper alloy sputtering target of embodiments of the present invention are not subject to significant restriction, and the existence of these gas components is tolerable up to roughly 100wtppm, respectively. Nevertheless, these gas components form an inclusion on the crystal grain boundary, and sometimes weaken the effect of adding Mn. Thus, in such a case, it would be preferable to keep each of these gas components to be 50wtppm or less, and more preferably 40wtppm or less.

These gas components cause the generation of particles during the sputtering of a target, and in particular cause a problem of generating unexpected particles during the sputter life, and it is evident that it is desirable to reduce such particles as much as possible.

Further, if the oxygen causes the formation of copper oxide (Cu₂O) on the seed layer, during the electrolytic plating, there is a problem in that Cu will not be deposited on that portion. When the seed layer surface is immersed in a plating bath, there is a problem in that the electric field will fluctuate on a micro scale, and a uniform plated film cannot be formed. Thus, it is necessary to limit the gas components such as oxygen to be within the foregoing range.

### [Examples]

Embodiments of the present invention are now explained in detail with reference to the Examples. These Examples are merely illustrative, and the present invention shall in no way be limited thereby.

### (Examples 1 to 6)

High purity copper (Cu) having a purity level of 6N or higher and manganese (Mn) of a 5N level were blended and melted in a high vacuum environment with a high purity graphite crucible to obtain high purity alloy. The blended alloy compositions of Examples 1 to 6 are shown in Table 1.

The alloyed molten metal was cast in a water-cooled copper casting mold in a high vacuum environment to obtain an ingot. Subsequently, the surface layer of the manufactured ingot was removed to attain *φ* 85 × 100h, the ingot was thereafter heated to 350°C, and subject to hot forging (forging was performed once) to attain *φ* 105 × 65h, and further subject to hot rolling in the subsequent step. However, with respect to Example 3 only, the ingot was subject to hot forging (first forging) to attain *φ* 105 × 65h, subsequently re-heated to 350°C, subject to clamp forging (second forging) to attain *φ* 85 × 100h, and subject to hot upset forging (third forging) to attain *φ* 105 × 65h. The number of times forging is performed is arbitrary.

Subsequently, hot rolling was performed at 400°C to roll the ingot to *φ* 200 × 18t, and further rolled to *φ* 300 × 7.5t with cold rolling. The rolling conditions are the same in Examples 1 to 6.

Subsequently, after performing heat treatment at 300 to 500°C for 0.5 to 1 hour, the overall target was quenched to obtain a target material. Although heat treatment in Table 1 is performed at a heat treatment temperature of 350°C for 0.5 hours, this temperature can be arbitrarily selected according to the target composition, working process and size. A condition particularly required in this working process and heat treatment is the adjustment of the close-packed (111) face. This is influenced by the working history, heat treatment history, and component composition.

With the Examples of the present invention, when the area ratio of a target surface in a case where a close-packed (111) face measured with EBSP (Electron Back Scatter Diffraction Pattern) is evenly distributed in all directions is 1, conditions were selected so that area ratio of the (111) face of the target surface is 4 or less.

Subsequently, the target was machined to obtain a target having a diameter of 300mm and thickness of 6.35mm, and further bonded with a Cu alloy backing plate via diffusion bonding to obtain a sputtering target assembly. Examples 1 to 7, as shown in Table 1, are added with 0.07 to 18.5wt% of manganese. With respect to the contents shown in Table 1, the Mn content is based on a chemical analysis value. The impurities of metal components are Be, B, Mg, Al, Si, Ca, Ba, La, and Ce show the total analytical amount thereof in Table 1. This is based on GDMS (Glow Discharge Mass Spectrometry) analysis.

The total amounts shown in the Examples are within the range of 1.5 to 185wtppm. These values satisfy the range of an embodiments of the present invention the present invention; specifically, the total amount being 500wtppm or less.

As the evaluation of the copper alloy wiring for semiconductor application shown in the Examples, after forming silicon oxide on the silicon substrate, the target was subject to sputter deposition, and the film resistance was checked. This was subsequently subject to heat treatment in a vacuum atmosphere at 400°C to form a manganese oxide layer.

If the temperature is lower than 200°C, it is not possible to form a stable manganese oxide layer. The temperature of higher than 525°C is inappropriate since the Cu will diffuse before the manganese oxide layer is formed. Preferably, the temperatue is 300°C to 450°C. Subsequently, after measuring the film resistance, the temperature was raised even further (850°C) to evaluate the status of Cu diffusion (barrier properties) in the silicon substrate with SIMS (Secondary Ion Mass Spectrometry).

Moreover, in order to evaluate the EM resistance (electromigration) characteristics, the foregoing target was used for sputter deposition to form a seed layer in the wiring groove having a SiO₂ interlayer insulating film. The barrier layer was thereafter self-formed in a vacuum atmosphere at a temperature of 400°C. The wiring groove was embedded with Cu electrolytic plating, and the upper part was flattened with CMP (Chemical Mechanical Polishing) to form a wiring having a wiring width of 0.2*µ*m. Current was applied to this wiring to evaluate the wiring disconnection rate.

In addition, the foregoing target was used to embed the wiring groove having an interlayer insulating film, and the upper part thereof was flattened with CMP. This was thereafter subject to heat treatment at 400°C in a nitrogen atmosphere containing 0.01vol% of oxygen, and a manganese oxide film was also formed on the upper part of the wiring.

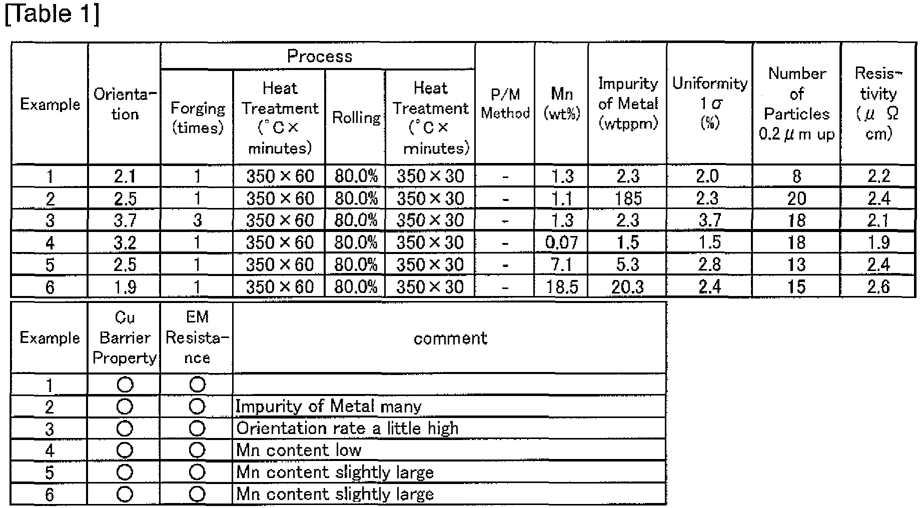

### (Film Characteristics and Evaluation of Example 1)

Example 1 contains 1.3wt% of Mn, and the total amount of Be, B, Mg, Al, Si, Ca, Ba, La, and Ce is 2.3wtppm. The manufacturing conditions of the target are shown in Table 1. As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 2.2*µ*Ωcm). This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce was reduced to 2.3wtppm.

In Example 1, as the structure of the Cu-Mn alloy sputtering target for forming the semiconductor wiring of the embodiment of the present invention, when the area ratio of a target surface in a case where a close-packed (111) face measured with EBSP (Electron Back Scatter Diffraction Pattern) is evenly distributed in all directions is 1, the area ratio of the (111) face of the target surface was set to be 2.1. Thereby, the uniformity 1 *σ* was 2.0%, and there were 8 particles that are 0.2*µ*m or larger. The gas components as impurities are shown in Table 2. Here, the oxygen content was 20wtppm, the nitrogen content was 20wtppm, and the carbon content was 30wtppm. It is considered that the reduction of these gas components is contributing to the prevention of the generation of particles in comparison to the Comparative Examples described later.

As a comprehensive evaluation, Example 1 showed extremely favorable characteristics. Similar to the above, not only is the embodiment of the present invention present invention effective in forming a seed layer, this shows that Example 1 is also extremely effective as a wiring material for semiconductor application.

**[Table 2]**

| Example | Impurities (wtppm) | | |
|---|---|---|---|
| | Oxygen | Nitrogen | Carbon |
| 1 | 20 | 20 | 30 |
| 2 | 40 | 30 | 30 |
| 3 | 20 | 20 | 30 |
| 4 | 20 | 10 | 20 |
| 5 | 30 | 20 | 40 |
| 6 | 40 | 10 | 20 |

### (Film Characteristics and Evaluation of Example 2)

Example 2 contains 1.1wt% of Mn, and the total amount of Be, B, Mg, Al, Si, Ca, Ba, La, and Ce is 185wtppm. The manufacturing conditions of the target are as shown in Table 1. As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 2.4*µ*Ωcm). This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce reduced was 185wtppm, and within the range of an embodiments of the present invention the present invention. Nevertheless, in comparison to Example 1, the amount of impurities is greater.

In Example 2, as the structure of the Cu-Mn alloy sputtering target for forming the semiconductor wiring of an embodiments of the present invention, when the area ratio of a target surface in a case where a close-packed (111) face measured with EBSP (Electron Back Scatter Diffraction Pattern) is evenly distributed in all directions is 1, the area ratio of the (111) face of the target surface was set to be 2.1.

Thereby, the uniformity 1 *σ* was 2.3%, and there were 20 particles that are 0.2*µ*m or larger. The main reason why the uniformity and particle count were greater in comparison to Example 1 is considered to be that the total amount of Be, B, Mg, Al, Si, Ca, Ba, La, and Ce is greater. The gas components as impurities are shown in Table 2. Here, the oxygen content was 40wtppm, the nitrogen content was 30wtppm, and the carbon content was 30wtppm. It is considered that the reduction of these gas components is contributing somewhat to the prevention of the generation of particles in comparison to the Comparative Examples described later.

As a comprehensive evaluation, Example 2 showed favorable characteristics. Similar to the above, not only is the embodiment of the present invention effective in forming a seed layer, this shows that Example 2 is also extremely effective as a wiring material for semiconductor application.

### (Film Characteristics and Evaluation of Example 3)

Example 3 contains 1.3wt% of Mn, and the total amount of Be, B, Mg, Al, Si, Ca, Ba, La, and Ce is 2.3wtppm. The manufacturing conditions of the target are shown in Table 1.

As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 2.1*µ*Ωcm). This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce is extremely low at 2.3wtppm.

Thereby, the uniformity 1 *σ* was 3.7%, and there were 18 particles that are 0.2*µ*m or larger. The main reason why the uniformity and particle count were greater in comparison to Example 1 is considered to be that the area ratio of the (111) face of the target surface was high.

The gas components as impurities are shown in Table 2. Here, the oxygen content was 20wtppm, the nitrogen content was 20wtppm, and the carbon content was 30wtppm. It is considered that the reduction of these gas components is contributing to the prevention of the generation of particles in comparison to the Comparative Examples described later.

In Example 3, forging was performed three times as described above. When the area ratio of a target surface in a case where a close-packed (111) face measured with EBSP (Electron Back Scatter Diffraction Pattern) is evenly distributed in all directions is 1, the area ratio of the (111) face of the target surface was 3.7, and close to the condition of 4 or less as prescribed in the embodiments of the present invention.

Although this is heading toward the deterioration of the uniform distribution of the (111) face orientation, it is still within the condition of the embodiment of the present invention. Since the tendency of the uniform distribution of the (111) face orientation becoming inferior is considered to be caused by the number of times forging is performed, it could be said that it would be preferable to limit the number of times forging up to three times.

The gas components as impurities are shown in Table 2. Here, the oxygen content was 20wtppm, the nitrogen content was 20wtppm, and the carbon content was 30wtppm. It is considered that the reduction of these gas components is contributing to the prevention of the generation of particles in comparison to the Comparative Examples described later. As a comprehensive evaluation, Example 3 showed favorable characteristics. Similar to the above, not only is the embodiment of the present invention effective in forming a seed layer, this shows that Example 3 is also extremely effective as a wiring material for semiconductor application.

### (Film Characteristics and Evaluation of Example 4)

Example 4 contains 0.07wt% of Mn, and the total amount of Be, B, Mg, Al, Si, Ca, Ba, La, and Ce is 1.5wtppm. The manufacturing conditions of the target are shown in Table 1.

As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 1.9*µ*Ωcm).

This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce is extremely low at 1.5wtppm. Nevertheless, in comparison to Example 1, the Mn content is close to the lower limit at 0,07wt%, and the area ratio of the (111) face of the target surface is somewhat large at 3.2.

In Example 4, as the structure of the Cu-Mn alloy sputtering target for forming the semiconductor wiring of the embodiment of the present invention, when the area ratio of a target surface in a case where a close-packed (111) face measured with EBSP (Electron Back Scatter Diffraction Pattern) is evenly distributed in all directions is 1, the area ratio of the (111) face of the target surface was set to be 3.2.

Thereby, the uniformity 1 *σ* was 1.5%, and there were 18 particles that are 0.2*µ*m or larger. The main reason why the particle count was greater in comparison to Example 1 is considered to be that the area ratio of the (111) face of the target surface is slightly large, and the Mn content is slightly low. The gas components as impurities are shown in Table 2. Here, the oxygen content was 20wtppm, the nitrogen content was 10wtppm, and the carbon content was 20wtppm. It is considered that the reduction of these gas components is contributing somewhat to the prevention of the generation of particles in comparison to the Comparative Examples described later. As a comprehensive evaluation, Example 4 showed favorable characteristics. Similar to the above, not only is the embodiment of the present invention effective in forming a seed layer, this shows that Example 4 is also extremely effective as a wiring material for semiconductor application.

### (Film Characteristics and Evaluation of Example 5)

Example 5 contains 7.1wt% of Mn, and the total amount of Be, B, Mg, Al, Si, Ca, Ba, La, and Ce is 5.3wtppm. The manufacturing conditions of the target are as shown in Table 1. As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 2.4*µ*Ωcm). This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce reduced extremely low at 5.3wtppm. Nevertheless, in comparison to Example 1, the amount of Mn content is greater at 7.1wt%.

In Example 5, as the structure of the Cu-Mn alloy sputtering target for forming the semiconductor wiring of the embodiment of the present invention, when the area ratio of a target surface in a case where a close-packed (111) face measured with EBSP (Electron Back Scatter Diffraction Pattern) is evenly distributed in all directions is 1, the area ratio of the (111) face of the target surface was set to be 2.5.

Thereby, the uniformity 1 *σ* was 2.8%, and there were 13 particles that are 0.2*µ*m or larger. The main reason why the particle count was greater in comparison to Example 1 is considered to be that the Mn content was slightly high. The gas components as impurities are shown in Table 2. Here, the oxygen content was 30wtppm, the nitrogen content was 20wtppm, and the carbon content was 40wtppm. It is considered that the reduction of these gas components is contributing somewhat to the prevention of the generation of particles in comparison to the Comparative Examples described later. As a comprehensive evaluation, Example 5 showed favorable characteristics. Similar to the above, not only is the embodiment of the present invention effective in forming a seed layer, this shows that Example 5 is also extremely effective as a wiring material for semiconductor application.

### (Film Characteristics and Evaluation of Example 6)

Example 6 contains 18.5wt% of Mn, and the total amount of Be, B, Mg, Al, Si, Ca, Ba, La, and Ce is 20.3wtppm. The manufacturing conditions of the target are shown in Table 1. As a result, when the copper alloy wiring for semiconductor application and the seed layer are formed, as shown in Table 1, the Cu diffusion resistance (barrier properties) was superior in both cases, and showed favorable EM resistance characteristics (few disconnections) and film resistance (low resistance of 2.6*µ*Ωcm). This is because manganese is diffused on the upper part, side face and bottom part of the wiring to form a favorable barrier film, and the resistance at the center of the wiring is reduced. The reason why few disconnections could be observed is considered to be that the total amount of Be, B, Mg, Al, Si, Ca, Ba, La, and Ce reduced extremely low at 20.3wtppm. Nevertheless, in comparison to Example 1, the amount of Mn content is greater at 18.5wt%.

In Example 6, as the structure of the Cu-Mn alloy sputtering target for forming the semiconductor wiring of the embodiment of the present invention, when the area ratio of a target surface in a case where a close-packed (111) face measured with EBSP (Electron Back Scatter Diffraction Pattern) is evenly distributed in all directions is 1, the area ratio of the (111) face of the target surface was set to be 1.9.

Thereby, the uniformity 1 *σ* was 2.4%, and there were 15 particles that are 0.2*µ*m or larger. The main reason why the particle count was greater in comparison to Example 1 is considered to be that the Mn content was slightly high. The gas components as impurities are shown in Table 2. Here, the oxygen content was 40wtppm, the nitrogen content was 10wtppm, and the carbon content was 20wtppm. It is considered that the reduction of these gas components is contributing somewhat to the prevention of the generation of particles in comparison to the Comparative Examples described later. As a comprehensive evaluation, Example 6 showed favorable characteristics. Similar to the above, not only is the embodiment of the present invention effective in forming a seed layer, this shows that Example 6 is also extremely effective as a wiring material for semiconductor application.

### (Comparative Examples 1 to 5)

With respect to Comparative Examples 1 to 5, only the conditions shown in Table 3 were changed, and the remaining conditions are all the same as the conditions of Examples 1 to 6.

### (Film Characteristics and Evaluation of Comparative Example 1)

Comparative Example 1 contains 1.3wt% of Mn, and the total amount of Be, B, Mg, Al, Si, Ca, Ba, La, and Ce is 2.3wtppm. The manufacturing conditions of the target are shown in Table 3. As a result, when the copper alloy wiring for semiconductor application and the seed layer are formed, as shown in Table 3, although there was no problem concerning the Cu diffusion resistance (barrier properties), EM resistance characteristics (few disconnections) and film resistance (low resistance of 2.3*µ*Ωcm), the uniformity 1 *σ* was 4.6% and there were 102 particles that are 0.2*µ*m or larger, and shows inferior results.

Moreover, when the area ratio of a target surface in a case where a close-packed (111) face measured with EBSP (Electron Back Scatter Diffraction Pattern) is evenly distributed in all directions is 1, the area ratio of the (111) face of the target surface was 4.5, and exceeded the condition of 4 or less as defined in an embodiment of the present invention. In other words, the distribution of the (111) face orientation was uneven.

In Comparative Example 1, forging was performed 5 times, and the forging steps that were performed are as follows. The ingot was subject to hot forging (first forging) to attain *φ* 105 × 65h, this was reheated to 350°C, then subject to clamp forging (second forging) to attain *φ* 85 × 100h, further subject to hot upset forging (third forging) to attain *φ* 105 × 65h, reheated to 350°C again, then subject to clamp forging (fourth forging) to attain *φ* 85 × 100h, further subject to upset forging (fifth forging) to attain *φ* 105 × 65h, and finally subject to hot rolling and cold rolling to attain *φ* 310 × 7.5t. It is obvious that excessive forging makes the distribution of the (111) face orientation uneven, and is therefore undesirable.

The gas components as impurities are similarly shown in Table 4. Here, the oxygen content was 20wtppm, the nitrogen content was 20wtppm, and the carbon content was 30wtppm. Nevertheless, even though these gas components were reduced, there were problems in that the uniformity was inferior, and the generation of particles increased. As a comprehensive evaluation, Comparative Example 1 showed inferior characteristics.

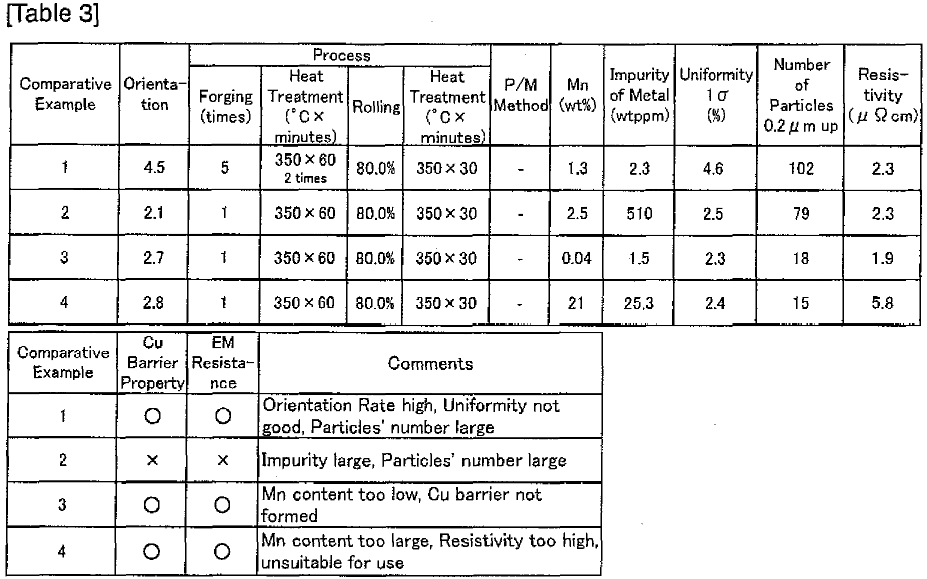

**[Table 4]**

| Comparative Example | Impurities (wtppm) | | |
|---|---|---|---|
| | Oxygen | Nitrogen | Carbon |
| 1 | 20 | 20 | 30 |
| 2 | 30 | 20 | 50 |
| 3 | 20 | 10 | 20 |
| 4 | 40 | 10 | 20 |

### (Film Characteristics and Evaluation of Comparative Example 2)

Comparative Example 2 contains 2.5wt% of Mn, and the total amount of Be, B, Mg, Al, Si, Ca, Ba, La, and Ce is 510wtppm. The manufacturing conditions of the target are shown in Table 3. As a result, when the copper alloy wiring for semiconductor application and the seed layer are formed, as shown in Table 3, although there was no problem concerning the Cu diffusion resistance (barrier properties), the EM resistance characteristics and film resistance (low resistance of 2.3*µ*Ωcm) were considerably inferior.

However, when the area ratio of a target surface in a case where a close-packed (111) face measured with EBSP (Electron Back Scatter Diffraction Pattern) is evenly distributed in all directions is 1, the area ratio of the (111) face of the target surface was 2.1, and fell within the scope of the embodiment of the present invention. In addition, although the uniformity 1 *σ* was 2.5% and showed no problem, there were 72 particles that are 0.2*µ*m or larger. The gas components as impurities are similarly shown in Table 4. Here, the oxygen content was 30wtppm, the nitrogen content was 20wtppm, and the carbon content was 50wtppm. Nevertheless, even though these gas components were reduced, there were problems in that the generation of particles increased. As a comprehensive evaluation, Comparative Example 2 showed inferior characteristics.

### (Film Characteristics and Evaluation of Comparative Example 3)

Comparative Example 3 contains 0.04wt% of Mn, and the total amount of Be, B, Mg, Al, Si, Ca, Ba, La, and Ce is a small amount at 1.5wtppm (less than present invention). The manufacturing conditions of the target are shown in Table 3. As a result, when the copper alloy wiring for semiconductor application and the seed layer are formed, as shown in Table 3, although there was no problem concerning the film resistance (low resistance of 1.9*µ*Ωcm), the Cu diffusion resistance (barrier properties) and the EM resistance characteristics (few disconnections) were considerably inferior. This is considered to be because the self-formation of the barrier layer was insufficient.

However, when the area ratio of a target surface in a case where a close-packed (111) face measured with EBSP (Electron Back Scatter Diffraction Pattern) is evenly distributed in all directions is 1, the area ratio of the (111) face of the target surface was 2.7, and fell within the scope of the embodiment of the present invention. In addition, the uniformity 1 *σ* was 2.3% and there were 18 particles that are 0.2*µ*m or larger, and these showed no particular problem. The gas components as impurities are similarly shown in Table 4. Here, the oxygen content was 20wtppm, the nitrogen content was 10wtppm, and the carbon content was 20wtppm. Nevertheless, even though these gas components were reduced, there were significant problems in that the Cu diffusion resistance (barrier properties) and EM resistance characteristics aggregated considerably. As a comprehensive evaluation, Comparative Example 3 showed inferior characteristics.

### (Film Characteristics and Evaluation of Comparative Example 4)

Comparative Example 4 contains 21wt% of Mn, and exceeds the condition of embodiments of the present invention. The total amount of Be, B, Mg, Al, Si, Ca, Ba, La, and Ce is 25.3wtppm. The manufacturing conditions of the target are as shown in Table 3. As a result, when the copper alloy wiring for semiconductor application and the seed layer are formed, as shown in Table 3, the film resistance was 5.8*µ*Ωcm. This is a result of the inclusion of a large amount of Mn. In addition, there were no problems concerning the Cu diffusion resistance (barrier properties) and the EM resistance characteristics. Nevertheless, the increase in film resistance is a significant problem, and is not suitable for practical application. As a comprehensive evaluation, Comparative Example 4 showed inferior characteristics.

### (Film Characteristics and Evaluation of Example 7)

Example 7 contains 1.0wt% of Mn, and the total amount of Be, B, Mg, Al, Si, Ca, Ba, La, and Ce is significant at 395wtppm, but still falls within the range of an embodiments of the present invention. The manufacturing conditions of the target, as shown in Table 5, employed the powder metallurgy method (P/M method). Cu powder and Mn powder of 50 mesh or less were mixed and filled in a graphite dice. Subsequently, the graphite dice was heated to 850°C in a vacuum, and subject to hot press of retaining it for 1 hour at a pressure of 250kg/cm². The obtained *φ* 360 × 10t disk was processed into a target and used in a sputter deposition test.

As a result, when the copper alloy wiring for semiconductor application and the seed layer are formed, as shown in Table 5, the film resistance was slightly higher at 3.5*µ*Ωcm. Nevertheless, there were no problems concerning the Cu diffusion resistance (barrier properties) and EM resistance characteristics.

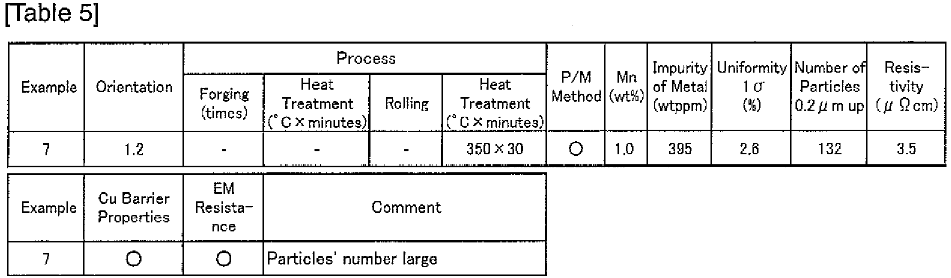

In addition, when the area ratio of a target surface in a case where a close-packed (111) face measured with EBSP (Electron Back Scatter Diffraction Pattern) is evenly distributed in all directions is 1, the area ratio of the (111) face of the target surface was low at 1.2, and fell within the scope of an embodiment of the present invention, and the uniformity 1 *σ* was favorable at 2.6%. Therefore, the target manufactured under the conditions of Example 7 is within a usable range.

With respect to the generation of particles, and there were 132 particles that are 0.2*µ*m or larger, and increased. The gas components as impurities are similarly shown in Table 6. Here, the oxygen content was 450wtppm, the nitrogen content was 30wtppm, and the carbon content was 40wtppm, and the oxygen content increased. This is considered to be caused by the generation of particles.

**[Table 6]**

| Example | Impurities (wtppm) | | |
|---|---|---|---|
| | Oxygen | Nitrogen | Carbon |
| 7 | 450 | 30 | 40 |

As a comprehensive evaluation, this would be an inferior evaluation in terms of the generation of particles as described above, but the only problem lies in the generation of particles, and there are no other problems regarding the other characteristics. Therefore, in order to overcome the problem concerning the generation of particles, it is necessary to adjust the contained oxygen content. In particular, preferably the oxygen content is 100wtppm, and more preferably 50wtppm.

Generally speaking, the generation of particles is not only a result of the target material, and is also caused by other factors. Thus, for instance, if an apparatus or structure capable of reducing the generation of particles via the shape of the target or backing plate or the method of mounting the target is available, the generation of particles caused by the target material can be relatively reduced. Thus, there are cases where this might not cause a significant problem in terms of the total amount. Accordingly, reduction of the oxygen content in the target should be adjusted in consideration of the foregoing factors.

As shown in the Examples and Comparative Examples, the utility of the Cu-Mn alloy sputtering target and the copper alloy wiring for semiconductor application according to an embodiment of the present invention in which the Mn contents is 0.05 to 20wt%, the total amount of Be, B, Mg, Al, Si, Ca, Ba, La, and Ce is 500wtppm or less, and the remainder is Cu and unavoidable impurities is evident, and the thin film wiring and the seed layer possess high conductivity and are equipped with a superior self-diffusion suppression function.

It is also evident that embodiments of the present invention yield a significant effect in that the uniformity of deposition during sputtering is favorable and the generation of particles is also reduced.

### INDUSTRIAL APPLICABILITY

Since the copper alloy wiring for semiconductor application according to an embodiment of the present invention is equipped with a self-diffusion suppression function, it yields a superior effect of being able to effectively prevent the contamination around the wiring caused by the diffusion of active Cu, and improve electromigration (EM) resistance, corrosion resistance, and the like. In addition, embodiments of the present invention yields a significant effect of being able to arbitrarily and stably form a barrier layer formed of manganese oxide on the upper face, lower face and peripheral face of the copper alloy wiring film, and simplify the deposition process of the copper alloy wiring and the formation process of the barrier layer. Moreover, by controlling the area ratio of the (111) face, an effect is yielded in that the uniformity of deposition during sputtering becomes favorable and the generation of particles is also reduced. Accordingly, embodiments of the present invention are extremely effective as a sputtering target for forming a copper alloy wiring for semiconductor application and for manufacturing such copper alloy wiring for semiconductor application.

## Claims

1. A Cu-Mn alloy sputtering target, wherein the Mn content is 0.05 to 20wt%, **characterised in that** the total amount of impurity elements having a stronger oxidizing power than Mn selected from a group consisting of Be, B, Mg, Al, Si, Ca, Ba, La, and Ce is 500wtppm or less, and the remainder is Cu and unavoidable impurities, wherein the area ratio of the (111) face of the target surface is 4 or less when measured by Electron Back Scatter Diffraction Pattern (EBSP) and calculated relative to an area ratio of 1 defined by a close-packed (111) face which is distributed evenly in all directions.

2. The Cu-Mn alloy sputtering target according to claim 1, wherein the total amount of of impurity elements having a stronger oxidizing power than Mn including Be, B, Mg, Al, Si, Ca, Ba, La, and Ce is 50wtppm or less.

3. The Cu-Mn alloy sputtering target according to claim 1, wherein the total amount of impurity elements having a stronger oxidizing power than Mn including Be, B, Mg, Al, Si, Ca, Ba, La, and Ce is 10wtppm or less.

4. The Cu-Mn alloy sputtering target according to any one of claims 1 to 3, wherein the oxygen content is 100wtppm or less.

5. The Cu-Mn alloy sputtering target according to any one of claims 1 to 3, wherein the oxygen content is 50wtppm or less.

## Patentansprüche

1. Cu-Mn-Legierungssputtertarget, wobei der Mn-Gehalt 0,05 bis 20 Gew.-% beträgt, **dadurch gekennzeichnet, dass** die Gesamtmenge von Verunreinigungselementen mit einer stärkeren Oxidationskraft als Mn, die aus einer Gruppe bestehend aus Be, B, Mg, Al, Si, Ca, Ba, La und Ce ausgewählt sind, 500 Gew.-ppm oder weniger beträgt und der Rest Cu und unvermeidbare Verunreinigungen ist, wobei das Flächenverhältnis der (111)-Fläche der Targetoberfläche 4 oder weniger beträgt, wenn es durch ein Elektronenrückstreubeugungsdiagramm (EBSP) gemessen und in Bezug auf ein Flächenverhältnis von 1 berechnet wird, das durch eine dicht gepackte (111)-Fläche definiert wird, die gleichmäßig in alle Richtungen verteilt ist.

2. Cu-Mn-Legierungssputtertarget nach Anspruch 1, wobei die Gesamtmenge von Verunreinigungselementen mit einer stärkeren Oxidationskraft als Mn, einschließlich Be, B, Mg, Al, Si, Ca, Ba, La und Ce, 50 Gew.-ppm oder weniger beträgt.

3. Cu-Mn-Legierungssputtertarget nach Anspruch 1, wobei die Gesamtmenge von Verunreinigungselementen mit einer stärkeren Oxidationskraft als Mn, einschließlich Be, B, Mg, Al, Si, Ca, Ba, La und Ce, 10 Gew.-ppm oder weniger beträgt.

4. Cu-Mn-Legierungssputtertarget nach einem der Ansprüche 1 bis 3, wobei der Sauerstoffgehalt 100 Gew.-ppm oder weniger beträgt.

5. Cu-Mn-Legierungssputtertarget nach einem der Ansprüche 1 bis 3, wobei der Sauerstoffgehalt 50 Gew.-ppm oder weniger beträgt.

## Revendications

1. Cible de pulvérisation cathodique d'alliage Cu-Mn, dans laquelle la teneur en Mn est de 0,05 à 20 % en poids, **caractérisée par le fait que** la quantité totale d'éléments d'impureté ayant un pouvoir oxydant plus fort que Mn choisis dans un groupe consistant en Be, B, Mg, Al, Si, Ca, Ba, La et Ce est de 500 ppm en poids ou moins, et le reste est Cu et les impuretés inévitables, dans laquelle le rapport de surface de la face (111) de la surface de cible est de 4 ou moins lorsqu'il est mesuré par un diagramme de diffraction d'électrons rétrodiffusés (EBSP) et calculé par rapport à un rapport de surface de 1 défini par une face (111) à grande compacité qui est distribuée de façon uniforme dans toutes les directions.

2. Cible de pulvérisation cathodique d'alliage Cu-Mn selon la revendication 1, dans laquelle la quantité totale d'éléments d'impureté ayant un pouvoir oxydant plus fort que Mn comprenant Be, B, Mg, Al, Si, Ca, Ba, La et Ce est de 50 ppm en poids ou moins.

3. Cible de pulvérisation cathodique d'alliage Cu-Mn selon la revendication 1, dans laquelle la quantité totale d'éléments d'impureté ayant un pouvoir oxydant plus fort que Mn comprenant Be, B, Mg, Al, Si, Ca, Ba, La et Ce est de 10 ppm en poids ou moins.

4. Cible de pulvérisation cathodique d'alliage Cu-Mn selon l'une quelconque des revendications 1 à 3, dans laquelle la teneur en oxygène est de 100 ppm en poids ou moins.

5. Cible de pulvérisation cathodique d'alliage de Cu-Mn selon l'une quelconque des revendications 1 à 3, dans laquelle la teneur en oxygène est de 50 ppm en poids ou moins.
